# EUROPEAN PATENT APPLICATION

(11) **EP 1 184 967 A2**
(43) Date of publication of application: **06.03.2002**
(21) Application number: 01106397.1
(22) Date of filing: 20.03.2001
(51) Int. Cl.: H03B 5/18

(54) **RF oscillator apparatus and transceiver apparatus**

(30) Priority: 11.07.2000 JP 2000209661
(71) Applicant: Hitachi, Ltd., Chiyoda-ku, Tokyo 101-8010 (JP)
(72) Inventor: Sekine, Kenji, Hitachi, Ltd.Intell.Property Group, Chiyoda-ku, Tokyo 100-8220 (JP); Kondoh, Hiroshi, Hitachi,Ltd.Intell.Property Group, Chiyoda-ku, Tokyo 100-8220 (JP); Kurita, Naoyuki, Hitachi,Ltd.Intell.Property Group, Chiyoda-ku, Tokyo 100-8220 (JP)
(74) Representative: Beetz & Partner Patentanwälte

(57) **Abstract**

The present invention can achieve a completely sub-modularized apparatus, prevent frequency thereof frombeing fluctuated and reduce manufacturing cost thereof. The present invention has a RF oscillator apparatus 10 whose frequency is set in advance and which is compactly sub-modularized; a transceiving module case 27, 28 which is a base substrate; a transceiving module upper cover 28 which is a seal material covering an upper portion of a conductive wall 4 of the RF oscillator apparatus 10; a RF circuit substrate 3 which is a wiring substrate loading the RF oscillator apparatus and a receiving mixer 18 and the like; and a bonding wire connecting the RF oscillator apparatus and the receiving mixer and the RF circuit substrate to each other. Since the RF oscillator apparatus whose oscillator frequency is set in advance and which is compactly sub-modularized is built into the transceiver apparatus, the RF oscillator apparatus and other RF circuits is easily connected to one another, it is possible to make the transceiver apparatus compact and a structure thereof simply.

## Description

### BACKGROUND OF THE INVENTION

The present invention relates to a RF oscillator apparatus, a transceiver apparatus, and technology for manufacturing the transceiver apparatus, and in particular, relates to technology which is effectively applied to compactly sub-modularize a RF oscillator apparatus to make a transceiver apparatus more compact and to improve the productivity thereof.

In a radar for vehicles, wireless LANs (Local Area Networks), and the like, there is the need for good stability of the frequency of an oscillator, from the standpoint of improvement of performance. For such structures, making the device compact and simple is an important factor from the standpoints of loadability and transportability.

As a method of improving the stability of the frequency of an oscillator, a method is known in which a resonator separated from a smoothing circuit such as a dielectric resonator is used in order to raise Q (an amount for expressing sharpness of the resonance) of a resonance circuit which determines the oscillation frequency.

It is known that, in an oscillator (RF oscillator apparatus) using a dielectric resonator, a conductor is disposed above the dielectric resonator with a gap between the dielectric resonator and the conductor and that resonance frequency varies when the gap is varied.

The technology of oscillators utilizing such a technique is disclosed in, for example, Japanese Patent Laid-open No. 61-252702 or No. 11-154823.

Each of the above-mentioned two references discloses an oscillator in which a semiconductor chip (a semiconductor element) and a dielectric resonator are packaged. The oscillator has such a structure that a metal screw is provided at a cap (cover) which covers the oscillator as a whole, and the screw is disposed above the dielectric oscillator. By raising and lowering the screw, distance between the screw and the dielectric oscillator is varied and, thereby, the oscillation frequency of the oscillator is adjusted.

In the aforementioned technology, each of oscillators disclosed in Japanese Patent Laid-open No. 61-252702 and No. 11-154823 has a sealed structure in which the oscillator is entirely covered by the cap (cover). However, since the screw for adjusting the resonance frequency is provided at a portion of the cap in this sealed structure, it is difficult to make an entirety of the cap having an airtight structure. Further, as the airtightness decreases, a problem arises in that the reliability of the semiconductor part is reduced.

Japanese Patent Laid-open No. 61-252702 discloses a structure in which a separate wall covering the screw for resonance frequency adjustment and preventing a deterioration of the airtightness within the cap is provided at an inner side of the cap. In this case, the structure in the cap becomes complicated, and as a result, a problem arises in that the oscillator cannot be made more compact.

Further, in a case in which a transceiver apparatus is constituted by using an oscillator, the transceiver apparatus on the whole becomes large due to, for example, the need for a connectors for connecting the oscillator and other RF circuits to one another. In transceiver apparatuses or the like for vehicles, in particular, the number of parts increases and, thereby, the structure becomes complicated and weak with respect to mechanical vibrations.

In this case, problems arise in that the transceiver apparatus is inappropriate for use as a vehicle-mounted transceiver apparatus, and cannot achieve compaction and a simplified structure.

Moreover, in order to make more compact a device (module) utilizing a dielectric resonator, structures for loading of the dielectric resonator and an MMIC chip (Monolithic Microwave Integrated Circuit chip) are disclosed in, for example, Japanese Patent Laid-open No. 9-232825 and No. 5-267940.

Here, Japanese Patent Laid-open No. 9-232825 discloses a technique in which a dielectric resonator is multilayered on the MMIC chip, and surface area occupied by both dispositions is made small, and the module can thereby be made more compact. However, there is no concrete disclosure of examples for applying this structure to a transceiver apparatus, a method for adjusting the resonance frequency of the dielectric resonator, a method of making the module airtight, or the like.

Further, Japanese Patent Laid-open No. 5-267940 discloses a module (down converter) having a structure in which a dielectric resonator and an MMIC chip are mounted, and entirety of device thereof is sealed airtightly by a cap. After attachment of the cap, adjustment of the resonance frequency of the dielectric resonator is carried out from the outside by a bellows provided at the cap.

In this structure, the resonance frequency can be adjusted from outside the cap. Therefore, a problem arises in that, when the bellows is touched after frequency adjustment, the frequency thereof changes.

When assembling the module, an assembly process is carried out in which, after assembly has been completed, frequency adjustment is carried out from the outside of the cap, and if the frequency is satisfied, the product is completed. However, at this time, a problem arises in that, if there is a problem with a part of the module, the assembled module becomes defective and, thereby, yield of the modules is decreased.

### SUMMARY OF THE INVENTION

An object of the present invention is to provide a RF oscillator apparatus and transceiver apparatus for achieving compaction of sub-modularization thereof, and to provide a manufacturing process of the transceiver apparatus.

Another object of the present invention is to provide a RF oscillator apparatus and a transceiver apparatus whose structures are simplified, in which fluctuations in frequency are prevented, and which have low cost, and to provide a manufacturing process of the transceiver apparatus.

The above and other objects and the novel features of the present invention will be apparent from the following description and the appended drawings.

A summary of typical inventions among the inventions disclosed in the present application is briefly described hereinafter.

That is, a RF oscillator apparatus of the present invention comprises a conductor plate supporting a dielectric resonator and a microwave monolithic integrated circuit chip which is electromagnetically coupled to the dielectric resonator; and a conductive wall which determines a resonance frequency of the dielectric resonator, wherein the microwave monolithic integrated circuit chip and the dielectric resonator are provided on the same conductor plate.

According to the present invention, a RF oscillator apparatus is realized which is compactly sub-modularized and whose oscillation frequency (resonance frequency) can be set in advance.

And, a transceiver apparatus of the present invention comprises a RF oscillator apparatus having a conductor plate which supports a dielectric resonator, a microwave monolithic integrated circuit chip which is electromagnetically coupled to the dielectric resonator, and a conductive wall which determines a resonance frequency of the dielectric resonator; a receiving section which makes a RF signal generated from the RF oscillator apparatus a local oscillation signal of a mixer; and a transmitting section having an amplifier for amplifying power.

According to the present invention, such a structure can be realized that a RF oscillator apparatus, which is compactly sub-modularized and whose oscillation frequency (resonance frequency) is capable of being can be set in advance is built into a transceiver apparatus. In this way, the RF oscillator apparatus and the other RF circuits is easily connected to each other. Accordingly, it is possible to make the transceiver apparatus compact and make the structure thereof simple.

As a result, a strong structure sufficient to be maintained with respect to mechanical vibrations can be realized. Fluctuations in the frequency of the RF oscillator apparatus can thereby be prevented.

Accordingly, it is possible to improve the performance of the transceiver apparatus, and to effectively use the transceiver apparatus even as a vehicle-mounted transceiver apparatus.

Further, due to the structure in which the compactly sub-modularized RF oscillator apparatus is built-in, it is easy to make, airtight, the entire transceiver apparatus including the semiconductor chip (MMIC chip), and a transceiver apparatus improving airtightness can be realized. As a result, the reliability of the transceiver apparatus can be improved about airtightness.

Moreover, the method of adjusting the frequency is different from a method of adjusting a screw which is mounted to a cap. Thus, the structure of the present invention can be simplified, and the number of parts thereof can be reduced in comparison to a conventional screw-adjusting type structure. As a result, the costs of both the RF oscillator apparatus and the transceiver apparatus can be reduced.

Further, a manufacturing process of a transceiver apparatus of the present invention comprises the steps of: preparing a RF oscillator apparatus whose resonance frequency is set in advance, a first semiconductor chip constituting a receiving section which makes a RF signal generated from the RF oscillator apparatus a local oscillation signal of a mixer, and a second semiconductor chip constituting a transmitting section having an amplifier for amplifying power; fixing the RF oscillator apparatus and the first and second semiconductor chips to a module substrate by an adhesive; connecting wires of the module substrate to the RF oscillator apparatus and the first and second semiconductor chips by wire bonding, respectively; and airtightly sealing the RF oscillator apparatus and the first and second semiconductor chips loaded on the module substrate.

According to the present invention, the method has such a process that the transceiver apparatus is assembled by being built in to the compactly sub-modularized RF oscillator apparatus. Therefore, it is possible to easily assemble the transceiver apparatus, and to replace parts thereof if there is something wrong with the parts during the assembly thereof.

Accordingly, the present invention can improve the productivity and the yield of the transceiver apparatus.

Moreover, the present invention has the manufacturing process such that the RF oscillator apparatus whose frequency is adjusted in advance is built into and sealed in the transceiver apparatus as a sub-module. Thus, the RF oscillator apparatus which is a sub-module and whose frequency is adjusted can be completely covered. Accordingly, fluctuations in frequency generated after the transceiver apparatus is completely assembled, can be prevented.

In this way, the reliability of the transceiver apparatus can be improved about the frequency.

### BRIEF DESCRIPTION OF THE DRAWINGS

FIG. 1 is a partially broken perspective view illustrating an example of a structure of a RF oscillator apparatus which is a first embodiment of the present invention.
FIG. 2A is a view showing the sectional structure of the RF oscillator apparatus shown in FIG. 1, and is a sectional view taken along line A-A of FIG. 1.
FIG. 2B is a view showing the sectional structure of the RF oscillator apparatus shown in FIG. 1, and is an enlarged partial sectional view showing portion B of FIG. 2A.
FIG. 3A is a view showing an example of a supported state of a dielectric resonator in the RF oscillator apparatus shown in FIG. 1, and is a plane view.
FIG. 3B is a view showing an example of a supported state of a dielectric resonator in the RF oscillator apparatus shown in FIG. 1, and is a side view.
FIGs. 4A and 4B are views illustrating a supported state of a modified example of the supported state of the dielectric resonator shown in FIG. 3, wherein FIG. 4A is a plane view, and FIG. 4B is a side view.
FIG. 5A is a view showing a supported state of a modified example of the supported state of the dielectric resonator shown in FIG. 3, and is a plane view.
FIG. 5B is a view showing a supported state of a modified example of the supported state of the dielectric resonator shown in FIG. 3, and is a side view.
FIG. 6 is a partial perspective view illustrating an example of a state in which the RF oscillator apparatus of FIG. 1 is mounted on a module substrate.
FIG. 7 is partial perspective view illustrating the state that a RF oscillator apparatus being a modified example of the RF oscillator apparatus illustrated in FIG. 6, is mounted on a module substrate.
FIG. 8 is a sectional view illustrating an example of a method of setting an oscillation frequency of the RF oscillator apparatus illustrated in FIG. 1.
FIG. 9 is a circuit block diagram illustrating an example of a circuit of a transceiver apparatus which is the first embodiment of the present invention.
FIG. 10 is a wiring diagram illustrating an example of a wiring layout in a module substrate of the transceiver apparatus which is the first embodiment of the present invention.
FIG. 11 is a view illustrating an example of the structure of a transceiver apparatus which is the first embodiment of the present invention, and is a sectional view taken along line C-C of the module substrate of FIG. 10.
FIG. 12 is a manufacturing process flow diagram illustrating an example of assembly processes for the transceiver apparatus which is the first embodiment of the present invention.
FIG. 13 is a circuit block diagram showing a circuit of a transceiver apparatus being a modified example of the circuit of the transceiver apparatus illustrated in FIG. 9.
FIG. 14 is a wiring diagram showing the wiring layout in a RF circuit substrate of the transceiver apparatus of the modified example having the circuit shown in FIG. 13.
FIG. 15 is a sectional view taken along line D-D of the RF circuit substrate of the modified example shown in FIG. 14.
FIG. 16 is a sectional view showing an example of the structure of a RF oscillator apparatus using a cavity resonator of a second embodiment of the present invention.
FIG. 17 is a sectional view illustrating an example of a structure of a transceiver apparatus in which the RF oscillator apparatus shown in FIG. 16 is built-in.

### DESCRIPTION OF THE PREFERRED EMBODIMENTS

Hereinafter, embodiments of the present invention will be described in detail on the basis of the drawings. Note that, in the drawings for explaining the embodiments, members having the same functions are denoted by the same reference numerals, and repetitive description thereof will be omitted.

### (First Embodiment)

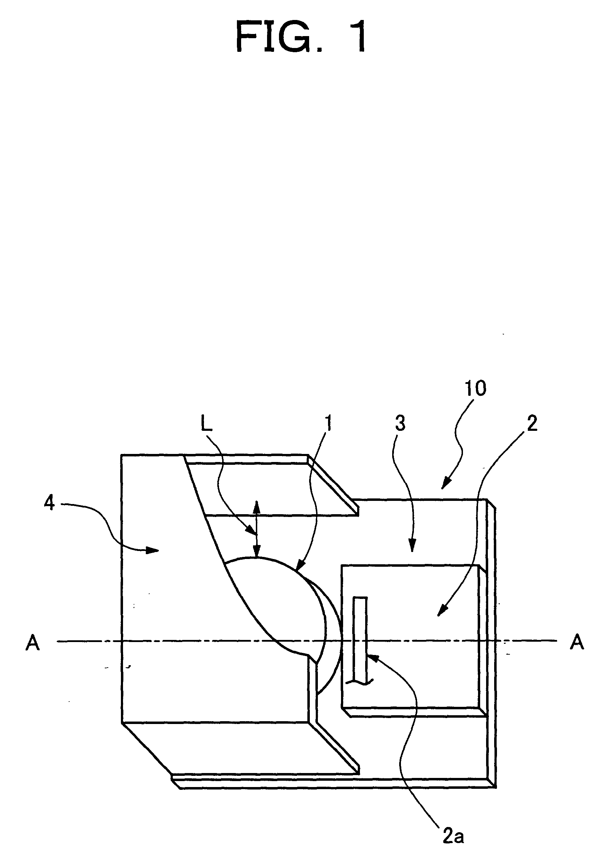

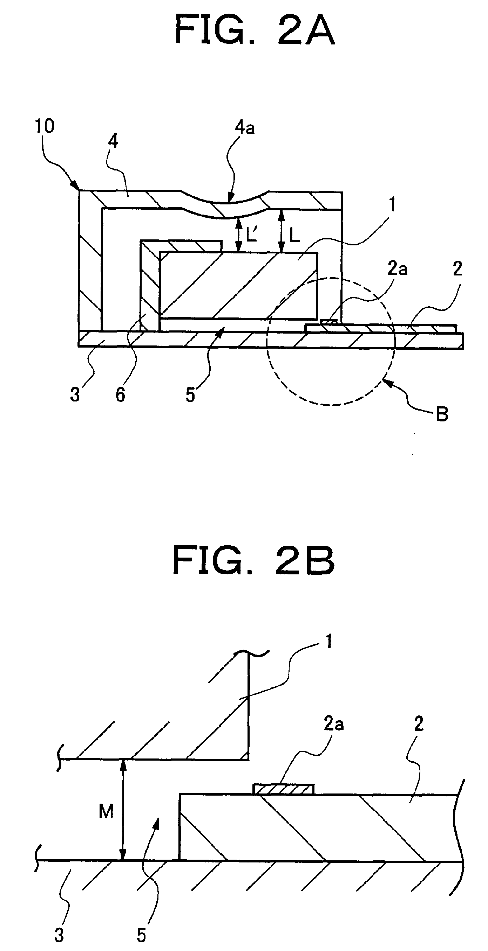

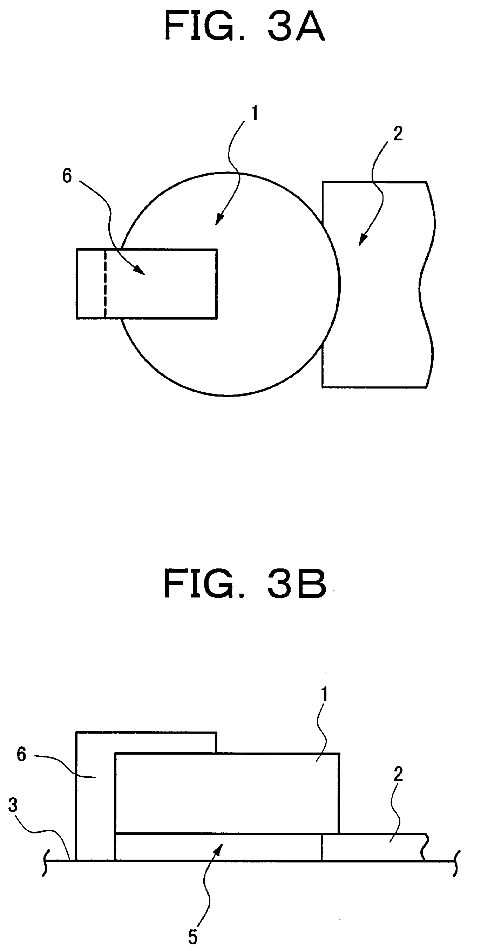

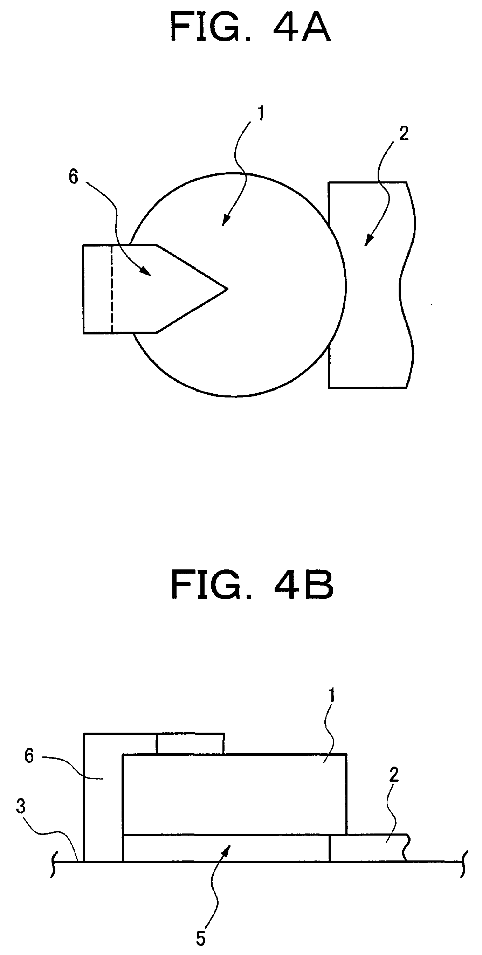

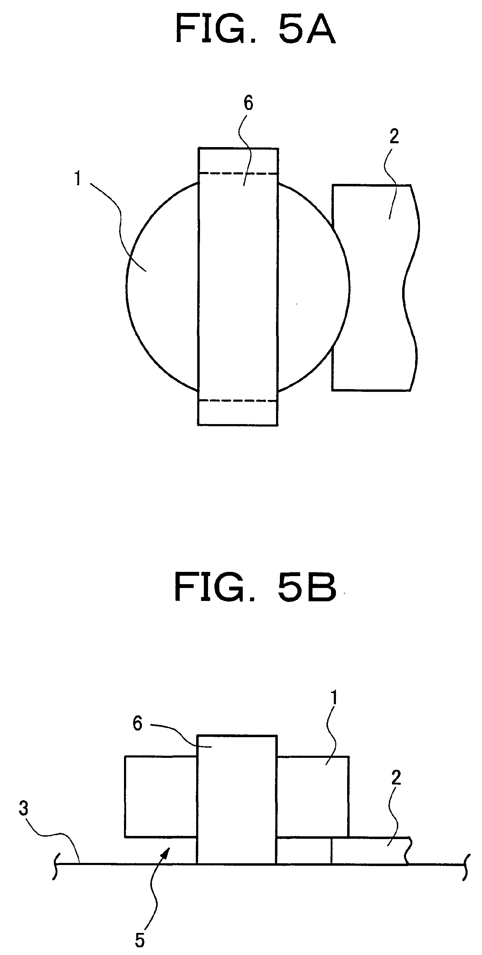

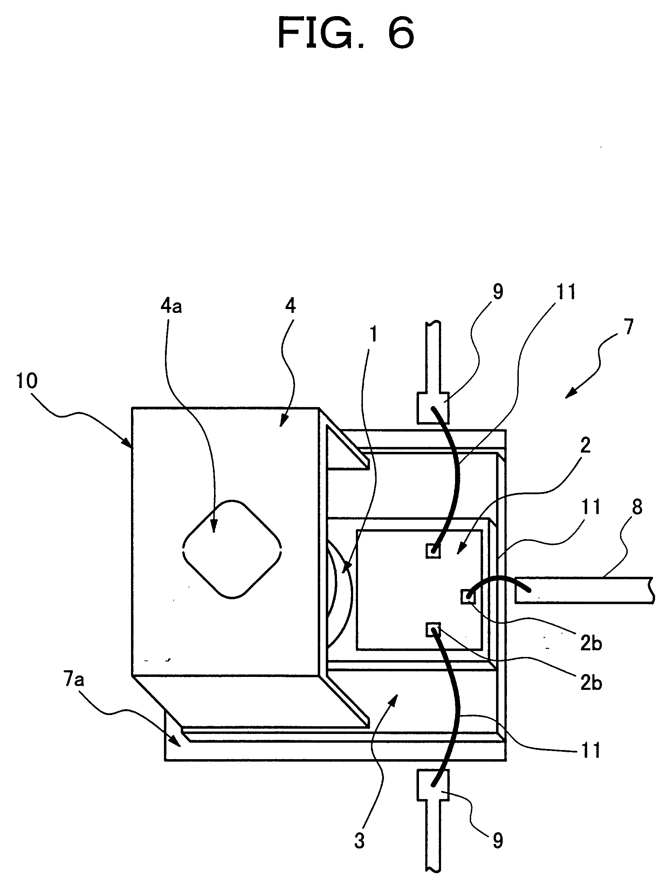

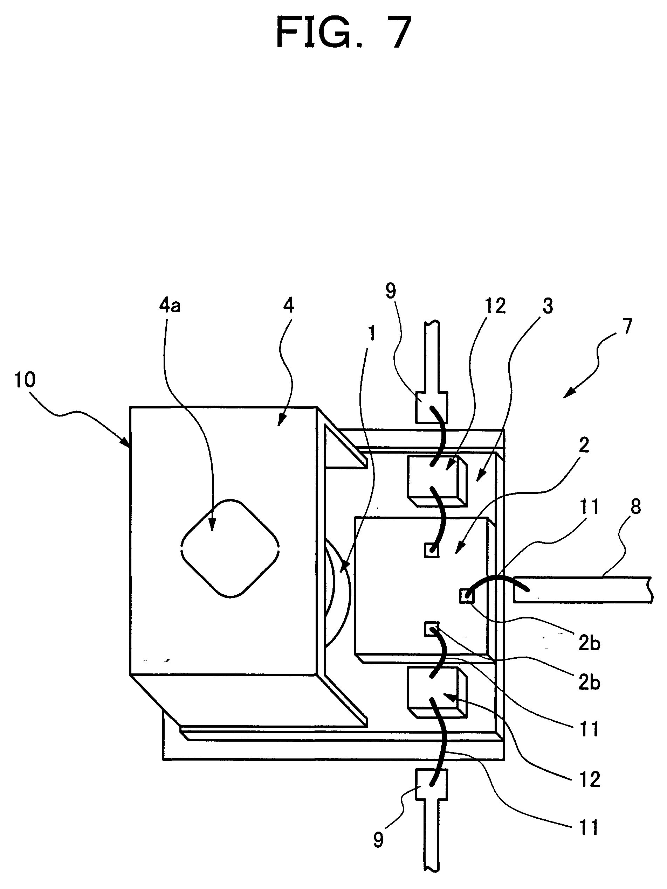

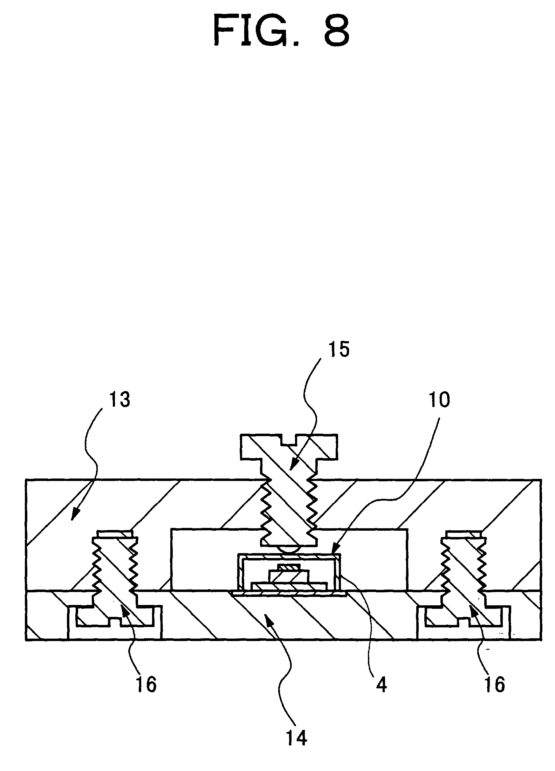

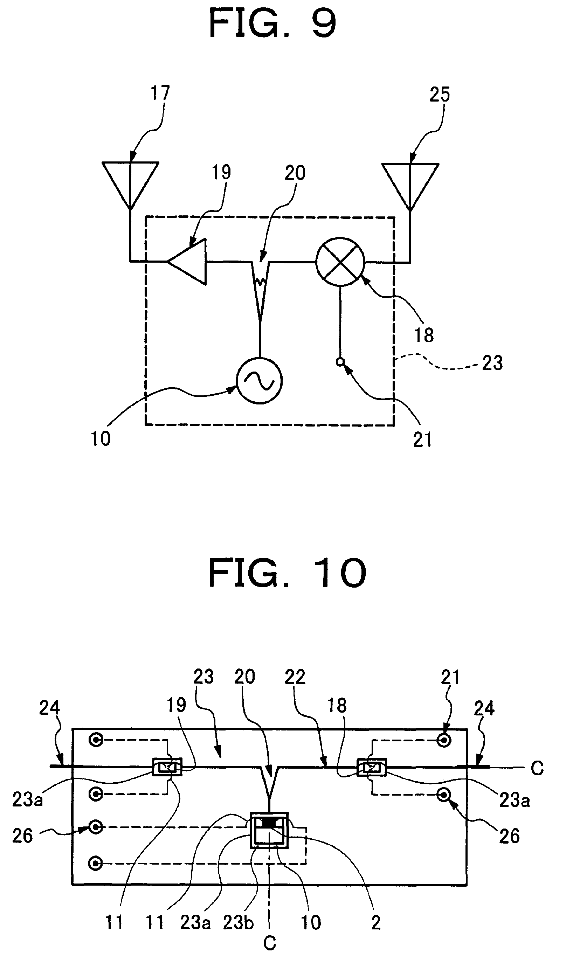

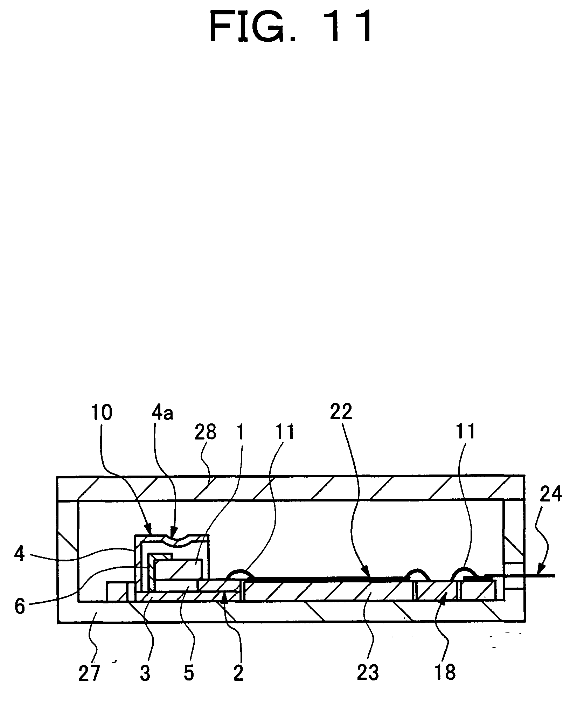

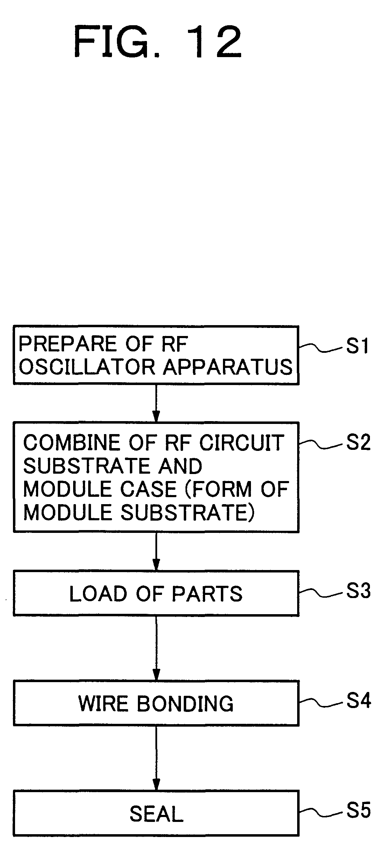

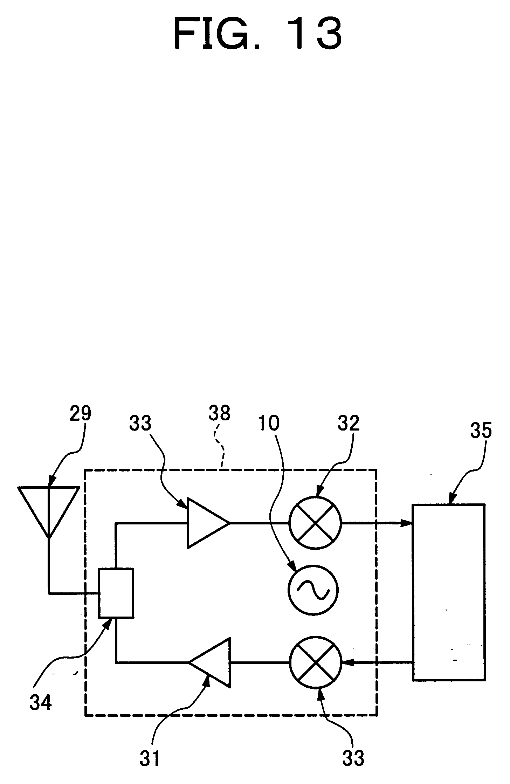

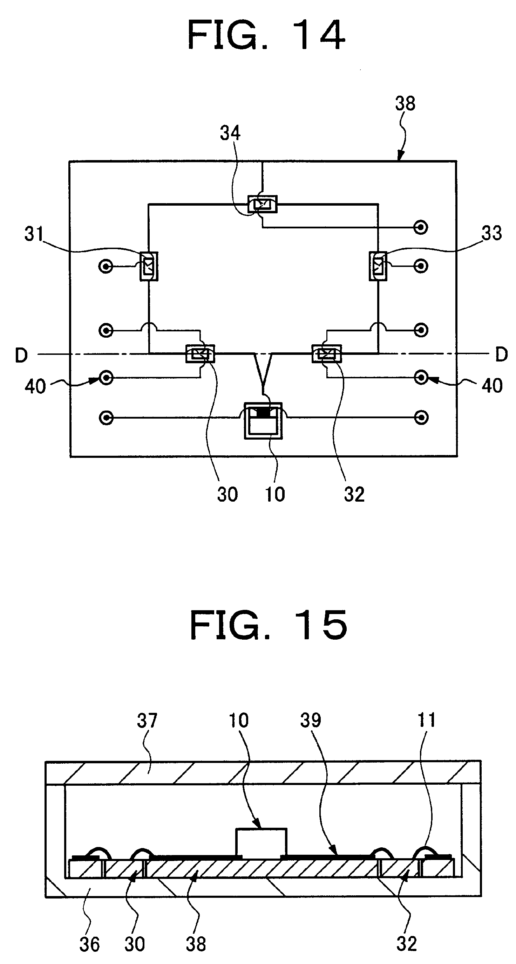

FIG. 1 is a partially broken perspective view showing an example of a structure of a RF oscillator apparatus which is a first embodiment of the present invention. FIGs. 2A and 2B are views showing the sectional structure of the RF oscillator apparatus shown in FIG. 1, wherein FIG. 2A is a sectional view taken along line A-A of FIG. 1, and FIG. 2B is an enlarged partial sectional view showing portion B of FIG. 2A. FIGs. 3A and 3B are views showing an example of a supported state of a dielectric resonator in the RF oscillator apparatus shown in FIG. 1, wherein FIG. 3A is a plane view, and FIG. 3B is a side view. FIGs. 4A and 4B are views showing a supported state of a modified example of the supported state of the dielectric resonator shown in FIG. 3, wherein FIG. 4A is a plane view, and FIG. 4B is a side view. FIGs. 5A and 5B are views showing a supported state of a modified example of the supported state of the dielectric resonator shown in FIG. 3, wherein FIG. 5A is a plane view, and FIG. 5B is a side view. FIG. 6 is a partial perspective view showing an example of a state in which the RF oscillator apparatus of FIG. 1 is mounted on a module substrate. FIG. 7 is partial perspective view illustrating the state that a RF oscillator apparatus being a modified example of the RF oscillator apparatus shown in FIG. 6, is mounted on a module substrate. FIG. 8 is a sectional view showing an example of a method of setting an oscillation frequency of the RF oscillator apparatus shown in FIG. 1. FIG. 9 is a circuit block diagram showing an example of a circuit of a transceiver apparatus which is the first embodiment of the present invention. FIG. 10 is a wiring diagram showing an example of a wiring layout in a module substrate of the transceiver apparatus which is the first embodiment of the present invention. FIG. 11 is a view showing an example of a structure of the transceiver apparatus which is the first embodiment of the present invention, and is a sectional view taken along line C-C of the module substrate of FIG. 10. FIG. 12 is a manufacturing process flow diagram showing an example of assembly processes for the transceiver apparatus which is the first embodiment of the present invention. FIG. 13 is a circuit block diagram showing a circuit of a transceiver apparatus being a modified example of the circuit of the transceiver apparatus shown in FIG. 9. FIG. 14 is a wiring diagram showing the wiring layout in a RF frequency circuit substrate of the transceiver apparatus of the modified example having the circuit shown in FIG. 13. FIG. 15 is a sectional view taken along line D-D of the RF frequency circuit substrate of the modified example shown in FIG. 14.

A RF oscillator apparatus 10 which is the first embodiment of the present invention has a compact structure in which a dielectric resonator and an MMIC chip 2 (a Microwave Monolithic Integrated circuit chip) are mounted on a single carrier (conductor plate) 3. The RF oscillator apparatus 10, for example, oscillates a RF frequency signal of 76 GHz, and is used for a vehicle-mounted radar, a wireless LAN, or the like.

The MMIC chip 2 is a semiconductor chip having a RF frequency integrated circuit which is formed on a single semiconductor substrate. The semiconductor substrate comprises an active element which is a function device for performing processes such as amplification, control, or the like, and a passive element such as a resistance, a capacitor, or the like.

First, to explain a basic structure of the RF oscillator apparatus 10, the RF oscillator apparatus 10 comprises a conductive carrier 3 and a conductive wall 4. The conductive carrier 3 supports both the dielectric resonator 1 and the MMIC chip 2 electromagnetically connected to the resonator 1. The conductive wall 4 can determine the resonance frequency (oscillation frequency) of the dielectric resonator 1. The MMIC chip 2 and the dielectric resonator 1 are provided on the same carrier 3.

Namely, the dielectric resonator 1 and the MMIC chip 2 are mounted on the same conductive carrier 3. Further, the conductive wall 4 is provided so as to surround the dielectric resonator 1. The RF oscillator apparatus 10 has an open structure at such a side portion that the conductive wall 4 is not provided on the conductive carrier 3 at which the MMIC chip 2 electromagnetically connected to the dielectric resonator 1 is disposed.

Accordingly, in the RF oscillator apparatus 10 of the first embodiment, as illustrated in FIGS. 1 and 2, the dielectric resonator 1 is surrounded by the conductive wall 4 at a top portion and the other side portions except for the side portion of the conductive carrier 3 at which the MMIC chip 2 is not disposed. The conductive wall 4 covers at least a top portion of the dielectric resonator 1.

The above-mentioned electromagnetic connection between the dielectric resonator 1 and the MMIC chip 2 means such a connection (coupling) that a RF signal is oscillated by the dielectric resonator 1 carrying out a resonating operation in response to electromagnetic waves generated from an electromagnetic wave forming line 2a formed at the MMIC chip 2.

Accordingly, the dielectric resonator 1 and the MMIC chip 2 are disposed within a distance which allows the dielectric resonator 1 to be connected to the electromagnetic wave generated by the electromagnetic wave forming line 2a of the MMIC chip 2.

Further, as illustrated in FIG. 2A, the resonance frequency (oscillation frequency) of the RF oscillator apparatus 10 is set (adjusted) by deforming (denting) a deforming portion 4a on the dielectric resonator side. The deforming portion 4a is provided with the conductive wall 4 deposing a vicinity of a position directly above the dielectric resonator 1.

Namely, the deforming portion 4a of the conductive wall 4 above an upper portion of the dielectric resonator 1 is dented in the dielectric resonator side. In this way, a distance L between the dielectric resonator 1 and the conductive wall 4 above the upper portion thereof is deformed to a distance L' (L > L') such that the resonance frequency is adjusted.

Adjustment of the resonance frequency (oscillation frequency) of the RF oscillator apparatus 10 is not limited to deformation of the conductive wall 4 above the upper portion of the dielectric resonator 1. The resonance frequency may be adjusted by deforming such a portion of the conductive wall 4 to correspond to a side portion except for the upper portion of the dielectric resonator 1 and by varying the distance between the dielectric resonator 1 and the conductive wall 4. The side portion of the dielectric resonator 1 is a portion not facing the MMIC chip electromagnetically connected to the dielectric resonator 1. Accordingly, the resonance frequency can be ad justedby varying the distance between the dielectric resonator 1 and at least one portion of the conductive wall 4 corresponding to the upper and side portions of the dielectric resonator 1.

As illustrated in FIG. 2, the dielectric resonator 1 is supported to have an air gap 5 between the dielectric resonator 1 and the carrier 3 by a dielectric supporter (dielectric supporting member) 6 mounted to the carrier 3.

This is because the dielectric resonator 1 has such characteristics as to be more easily affected by members disposed between the dielectric resonator 1 and the carrier 3. Namely, when the electromagnetic wave forming line 2a of the MMIC chip 2 generates electromagnetic waves and induces an electromagnetic field, current flows in the carrier 3 and Q (an amount of expression of the resonance strength) of the dielectric resonator 1 decreases.

Accordingly, if dielectric constant ε of the material disposed between the dielectric resonator 1 and the carrier 3 is made small, the effect on the characteristic of the dielectric resonator 1 can be made less.

In this way, the air gap 5 is formed between the dielectric resonator 1 and the carrier 3 and has air being the smallest constant (ε =1) among the dielectric constant ε. At this time, as shown in FIG. 2B, if the electromagnetically coupling between the dielectric resonator 1 and the MMIC 2 is the possible range, it is preferable to form a distance M being a length of the air gap 5 between the dielectric resonator 1 and the carrier 3 so as to be as large as possible.

Accordingly, in the RF oscillator apparatus 10 of the present first embodiment, by providing the air gap 5 between the dielectric resonator 1 and the carrier 3 therebeneath, a lowering of the Q of the dielectric resonator 1 due to the effect of the carrier 3 can be reduced.

Moreover, because the dielectric constant ε of the air is small, margin depending on changes in the distance between the dielectric resonator 1 and the carrier 3 can be made large with respect to fluctuations in the characteristic of the dielectric resonator 1. As a result, need for precision of the position for mounting the dielectric resonator 1 can be lessened when the dielectric resonator 1 is set. Or, if compared to the same positional accuracy, the fluctuations in the characteristic of the dielectric resonator 1 can be reduced.

A dielectric material other than the air gap, e.g., another dielectric formed from a material such as fluorine resin, glass epoxy resin, alumina, or the like, may be disposed between the dielectric resonator 1 and the carrier 3 therebeneath.

Here, the dielectric resonator 1 is formed from, for example, ceramic (dielectric constant ε = 30 to 40). The dielectric supporter 6 is formed from epoxy resin or fluorine resin (dielectric constant ε =2 to 4) or the like having a dielectric constant ε which is smaller than that of the dielectric resonator 1.

The conductive carrier 3 is, for example, copper plate or aluminum plate or the like. However, if at least the surface thereof is metal (metal plated or the like), the interior thereof may be formed of a resin such as plastic or the like.

The conductive wall 4 is freely plastically deformable, and is preferably formed from a material which has little loss of RF frequency waves. For example, a plate material of copper or iron is preferable. However, the surface of a copper plate or an iron plate or the like may be subjected to highly corrosion-resistant Au plating or Ni plating.

FIGs. 3 through 5 illustrate a supported state in which the dielectric resonator 1 is supported by the dielectric supporter 6.

FIGs. 3A and 3B show an example in which the dielectric supporter 6 supporting the dielectric resonator 1 is provided at a side opposite to the MMIC chip 2 side. At the upper portion of the dielectric resonator 1, the dielectric resonator 1 and the dielectric supporter 6 are joined by an epoxy adhesive or the like.

FIGS. 4A and 4B show, as a modified example of the respective supported states of FIGs. 3A and 3B, an example in which a joining surface area at the upper portion of the dielectric resonator 1 is smaller than that shown in FIGs. 3A and 3B, in order to reduce the effect of the dielectric supporter 6.

FIGs. 5A and 5B show, as a modified example of the supported state of FIGs. 3A and 3B, an example in which the dielectric supporter 6 is disposed so as to extend in a direction parallel to the MMIC chip 2 and straddle the dielectric resonator 1.

Namely, the dielectric supporter 6 is formed in such a shape as to straddle the both sides of the dielectric resonator 1 in a direction parallel to the MMIC chip 2, and is mounted to the carrier 3 at the both sides of the dielectric resonator 1. In this way, the dielectric supporter 6 and a portion of the upper portion of the dielectric resonator 1 are joined.

In accordance with the supported state of the modified example of FIGs. 5A and 5B, because the dielectric resonator 1 is supported at the both sides thereof, the mounting precision of the dielectric resonator 1 can be improved, and stability of the air gap 5 can be achieved.

In the supported states of the dielectric resonator 1 illustrated in FIGs. 3A, 3B, 4A, 4B, 5A and 5B, all of these cases have a gap (the air gap 5) formed by air between the dielectric resonator 1 and the carrier 3 except for a portion where the MMIC chip 2 is disposed. Due to this air gap 5, the Q of the dielectric resonator 1 can be prevented from decreasing by the effect of the conductive carrier 3, and contribute to improvement of the need for positional accuracy when the position of the dielectric resonator 1 is set.

Next, the detailed structure of the RF oscillator apparatus 10 which the present first embodiment, and a concrete example of a RF substrate (module substrate) 7 of a 76 GHz band thereof, are described with reference to FIG. 6.

FIG. 6 illustrates an example of a structure in a case in which the RF oscillator apparatus illustrated in FIG. 1 is sub-modularized, and is mounted to a circuit board forming a transceiving circuit.

The MMIC chip 2 using a GaAs substrate is, for example, about 1.2 mm × 2.2mm. The dielectric resonator 1 is cylindrical, and has a diameter of about 0.9 mm and a height of about 0.4 mm. The size of the entire carrier 3 including the conductive wall 4 surrounding the dielectric resonator 1 is about 3 mm × 4 mm. As a result, the height of the RF oscillator apparatus 10 is about 1.5 mm and is extremely small, and the RF oscillator apparatus 10 is easy to handle.

The RF oscillator apparatus 10 is disposed in a recess 7a formed in a RF substrate 7. A RF transmission line 8 provided at the RF substrate 7, and an electrode pad 2b being a surface electrode of the MMIC chip 2 are connected via a bonding wire 11 such as a metal wire or the like to each other. DC bias terminals 9 provided at the RF substrate 7, and the electrode pads 2b of the MMIC chip 2 are connected via the bonding wires 11 to each other.

FIG. 7 shows, as a modified example of packaged examples mounting onto the RF substrate 7 shown in FIG. 6, chip capacitors 12 provided on the carrier 3 which is a conductor plate, in order to apply DC bias or bias for modulation. The DC bias terminals 9 provided on the RF substrate 7 and the chip capacitors 12 are connected by the bonding wires 11 being metal wires or the like to each other. The chip capacitors 12 and the electrode pads 2b of the MMIC chip 2 are connected via the bonding wires 11 being metal wires or the like to each other, respectively.

In this way, the noise generated from an external power source can be suppressed. As a result, electrical stability of the overall RF oscillator apparatus 10 can be achieved, and the RF oscillator apparatus 10 is easily handled as a sub-module.

Next, a method of setting (method of adjusting) the oscillation frequency (resonance frequency) of the RF oscillator apparatus 10 which has been sub-modularized is described with reference to FIG. 8.

The RF oscillator apparatus 10 sub-modularized is mounted between implements 13 and 14 which are fit together by connecting screws 16. When the deforming portion 4a (FIG. 6) of the conductive wall 4 is inwardly deformed by a frequency adjusting screw 15, the distance L between the upper portion of the dielectric resonator 1 and the conductive wall 4 is deformed to distance L' (FIG. 2A) and, thereby, the oscillation frequency is set to a desired value.

In accordance with the RF oscillator apparatus 10 of the present first embodiment, it is possible to set the oscillation frequency thereof in advance, and the compact sub-modularization of the RF oscillator apparatus 10 can be realized.

Next, the structure of the transceiver apparatus which is the present first embodiment illustrated in FIG. 11 will be described with reference to FIGs. 1, 2A, 2B, and 9 through 11.

The transceiver apparatus uses the sub-modularized RF oscillator apparatus 10 of the present first embodiment, and the RF oscillator apparatus 10 whose oscillation frequency is set to a desired value in advance is built-into the transceiver apparatus.

The transceiver apparatus shown in FIG. 11 has the RF oscillator apparatus 10 for generating a desired RF signal as shown in FIGs. 1 and 2A and 2B, a receiving section for receiving the RF signal generated from the RF oscillator apparatus as a local oscillation signal of a mixer, and a transmitting section having an amplifier 19 for amplifying the power.

The RF oscillator apparatus 10 includes the dielectric oscillator 10, the carrier (conductor plate) 3 supporting the MMIC chip (Microwave Monolithic Integrated circuit chip) 2 electromagnetically connected to the dielectric oscillator 1, and the conductive wall 4 for determining the resonance frequency (oscillation frequency) of the dielectric resonator 1.

FIG. 9 shows a circuit block diagram of the above-mentioned transceiver apparatus. The RF signal generated from the RF oscillator apparatus 10 is divided into two by a distributor 20. One of the divisional signals is transmitted through the amplifier 19 from a transmitting antenna 17. The other signal is the local oscillation input for a receiving mixer 18. An intermediate frequency (IF) signal, which is obtained by the mixing operation induced between a receiving signal from a receiving antenna 25 and the IF signal, is taken out of an IF output terminal 21.

An amplifier is also included in the receiving mixer 18 which constitutes the above-mentioned receiving section. In the transceiver apparatus of the present first embodiment, the above-mentioned receiving section comprises the receiving mixer 18 and this amplifier. In addition, the receiving mixer 18 and the amplifier may be provided separately.

FIG. 10 shows a circuit structure of the transceiver apparatus illustrated in FIG. 9, and shows the concrete structure of a RF circuit substrate (wiring substrate) 23 which is a section surrounded by the dashed line in FIG. 9. The RF oscillator apparatus 10, the amplifier 19, and the receiving mixer 18 are mounted on the RF circuit substrate 23.

A microstrip line 22 being a transmission line, the IF output terminal 21, a RF transceiving terminal 24, and a DC bias terminal 26 are formed in the RF circuit substrate 23.

The receiving mixer 18 constituting the receiving section and the amplifier 19 constituting the transmitting section are provided as the MMIC chips.

Namely, the receiving mixer 18 and the amplifier 19 are formed in the form of the MMIC chips.

Next, the sectional structure of the transceiver apparatus which is the present first embodiment will be described.

FIG. 11 shows a cross section of the transceiver apparatus in which the sub-modularized RF oscillator apparatus 10 is built-in, and shows the cross-sectional structure of the transceiver apparatus as taken along line C-C of FIG. 10.

Namely, a transceiving circuit is set in the transceiver apparatus. The transceiving circuit includes the RF oscillator apparatus 10 packaging the MMIC chip 2 in a case which comprises a transceiving module case 27 being a base substrate and a transceiving module upper cover 28 being a seal material. The transceiving circuit is sealed by the transceiving module upper cover 28 being a seal material which covers the conductive wall 4 of the RF oscillator apparatus 10.

Airtight sealing of the interior of the transceiver apparatus can be easily realized by welding connecting surfaces for connecting the transceiving module case 27 and the transceiving module upper cover 28 to each other, and sealing the signal input/output terminals by glass or ceramic or the like.

In the transceiver apparatus of the present first embodiment, the module substrate serving as a transceiver apparatus is constituted by the RF circuit substrate 23 being the wiring substrate, and the transceiving module case 27 being is the base substrate.

Namely, the RF circuit substrate 23 and the transceiver apparatus module base 27 are joined by an adhesive such as silver paste or the like.

Here, in addition to the RF oscillator apparatus 10, the receiving mixer 18 and the amplifier 19, which are formed in a chip shape, are connected to the transceiving module case 27 by an adhesive such as silver paste. Namely, in the transceiver apparatus of the present first embodiment, as shown in FIG. 10, three through holes 23a are formed in the RF circuit substrate 23. By adhering the RF circuit substrate 23 and the transceiving module case 27 by silver paste, three recesses 23b are formed in the through holes 23a, respectively. The receiving mixer 18, the amplifier 19 and the RF oscillator apparatus 10 are joined by silver paste to these three recesses 23b.

By using silver paste as an adhesive, ground connection between the receiving mixer 18 and the amplifier 19 which are respectively in chip shape can be carried out by the silver paste.

Here, the transceiving module case 27 and the transceiving module upper cover 28 are formed from, for example, copper plates or aluminum plates. Or, if the surfaces thereof are metal plated by nickel plating or the like, the interiors thereof may be a resin material such as plastic.

Further, such a case-shaped substrate that the RF circuit substrate 23 and the transceiving module case 27 are formed integrally in advance, may be used as the module substrate of the transceiver apparatus. The shape of the module substrate is not limited to a case shape, and the module substrate may be a substantially flat substrate. In this case, it is necessary for the transceiving module upper cover 28 to have such a shape that the transceiving module case 27 shown in FIG. 11 is turned upside down.

FIG. 13 is a circuit block diagram of a transceiver apparatus which is a modified example of the circuit block diagram of the transceiver apparatus shown in FIG. 9.

In the transceiver apparatus of this modified example, an output signal from the RF oscillator apparatus 10 is supplied to a receiving mixer 32 and a transmitting mixer 30 as a local oscillation signal. Further, the transmitting signal from a base band section 35 is transmitted from an antenna 29 via the transmitting mixer 30, a transmitting amplifier 31, and an antenna switch 34 (or an antenna diplexer).

Further, the received waves from the antenna 29 are supplied to the base band section 35 via the antenna switch 34, a receiving amplifier 33 for low noise, and the receiving mixer 32.

FIG. 14 shows a circuit structure of the transceiver apparatus shown in FIG. 13, and shows a concrete structure of a RF circuit substrate (wiring substrate) 38 which is a portion surrounded by the dashed line in FIG. 13. The RF oscillator apparatus 10, the transmitting mixer 30, the transmitting amplifier 31, the receiving mixer 32, the receiving amplifier 33 for low noise, and the antenna switch 34 are mounted on the RF circuit substrate 38. Further, IF signal input/output terminals 40 are formed as the input/output terminals.

FIG. 15 shows a cross-section of a transceiver apparatus in a case in which the sub-modularized RF oscillator apparatus 10 of the present first embodiment is assembled into the transceiver apparatus of the modified example shown in FIG. 13. FIG. 15 shows the cross-sectional structure of the transceiver apparatus taken along line D-D of FIG. 14.

A transceiving circuit is set in the transceiver apparatus of the modified example shown in FIG. 15. The transceiving circuit includes the RF oscillator apparatus 10 of the first embodiment in a container which comprises a transceiving module case 36 being a base substrate and a transceiving module upper cover 37. The output from the RF oscillator apparatus 10 is applied through microstrip lines 39 to the transmitting mixer 30 and the receiving mixer 32 which are in chip forms.

The module substrate serving as the transceiver apparatus comprises a RF circuit substrate 38 being a wiring substrate and the transceiving module case 36 being a base substrate.

In accordance with the transceiver apparatus of the present first embodiment (and the transceiver apparatuses of the modified examples), the transceiver apparatus can achieve such a structure that the RF oscillator apparatus 10 whose the oscillation frequency is set in advance and which is compactly sub-modularized is built into the transceiver apparatus. Thus, the RF oscillator apparatus 10 and other RF circuits are easily connected to each other. Accordingly, the transceiver apparatus of the present first embodiment can achieve compactness thereof and, thereby, the structure can be simplified.

As a result, a transceiver apparatus which has a strong structure not affected even with respect to mechanical vibrations can be realized. Fluctuations in the frequency of the built-in RF oscillator apparatus 10 can thereby be prevented.

Accordingly, the performance of the transceiver apparatus can be improved, and the transceiver apparatus is effectively used even as a vehicle-mounted transceiver apparatus.

Further, because of the structure in which the compactly sub-modularized RF oscillator apparatus 10 is built-in, it is easy to make, airtight, the entire transceiver apparatus including the semiconductor chip (MMIC chip 2). A transceiver apparatus with improved airtightness can thereby be realized. As a result, reliability of the transceiver apparatus can be improved relative to airtight.

Moreover, the method of adjusting the frequency is not a method of adjusting a screw mounted to a cap. Thus, the structure of the transceiver apparatus can be simplified, and the number of parts thereof can be reduced in comparison with that of a conventional screw-adjusting type transceiver apparatus. As a result, the costs of manufacturing the RF oscillator apparatus 10 and the transceiver apparatus can be reduced.

Next, the manufacturing process of the transceiver apparatus which is the present first embodiment will be described in accordance with a manufacturing process flowchart shown in FIG. 12.

Here, an explanation will be made of a case of assembling the transceiver apparatus shown in FIG. 11, in which the RF oscillator apparatus 10 whose frequency can be set in advance and which is shown in FIG. 1 is mounted.

First, the compact RF oscillator apparatus 10, the receiving mixer 18, and the amplifier 19 are prepared. The compact RF oscillator apparatus 10 us sub-modularized and the frequency thereof is set in advance. The receiving mixer 18 is a first semiconductor chip constituting a receiving section which can receive the RF signal generated from the RF oscillator apparatus 10. The amplifier 19 shown in FIG. 10 is a second semiconductor chip which amplifies the power of the transmitted waves.

Here, the compact RF oscillator apparatus 10 which is sub-modularized has the dielectric resonator 1, the carrier (conductor plate) 3 which supports the MMIC chip 2 electromagnetically connected to the dielectric resonator 1, and the conductive wall 4 which determines the resonance frequency (oscillation frequency) of the dielectric resonator 1. And, the compact RF oscillator apparatus 10 of FIG. 1 whose frequency can be set in advance is used.

Accordingly, the compact RF oscillator apparatus 10 shown in FIG. 1 is prepared (step S1 shown in FIG. 12), and the oscillation frequency of the RF oscillator apparatus 10 is set to a desired frequency by, for example, using the implements 13 and 14 shown in FIG. 8.

When the RF oscillator apparatus 10 whose frequency setting is carried out in advance is prepared, the RF oscillator apparatus 10 whose assembly and frequency setting are carried out in advance may be delivered and prepared. Or, as the preparing process shown in step S1, assembly of the RF oscillator apparatus 10 may be carried out and then frequency setting may be carried out.

Further, in the present first embodiment, as illustrated in FIG. 11, the module substrate for the transceiver apparatus comprises the RF circuit substrate (wiring substrate) 23 connected to the RF oscillator apparatus 10 and the like by wire bonding, and the transceiving module case 27 being a base substrate supporting the RF circuit substrate 23.

The respective three through holes 23a for allocating the RF oscillator apparatus 10, the receiving mixer 18 and the amplifier 19 are formed in the RF circuit substrate 23.

Thereafter, silver paste as an adhesive is coated on the entire surface of the transceiving module case 27 by printing.

Next, as shown in step S2, the transceiving module case 27 and the RF circuit substrate 23 are combined with (adhere to) each other by silver paste, and the module substrate for the transceiver apparatus is formed.

By adhering to the transceiving module case 27 and the RF circuit substrate 23, the three recesses 23b for being capable of disposing the RF oscillator apparatus 10, the receiving mixer 18, and the amplifier 19 are provided in the module substrate by the through holes 23a formed in the transceiving module case 27.

Thereafter, loading of parts in step S3 is carried out to fix the RF oscillator apparatus 10, the receiving mixer 18, and the amplifier 19 at the module substrate by using the silver paste which is an adhesive.

Namely, first, as illustrated in FIG. 10, the RF oscillator apparatus 10, the receiving mixer 18, and the amplifier 19 are placed in the three recesses 23b of the module substrate.

At this time, silver paste is coated as an adhesive on the entire surface of the transceiving module case 27. Thus, after heating or the like is carried out, the RF oscillator apparatus 10, the receiving mixer 18, and the amplifier 19 are fixed to the respective recesses 23b by the silver paste.

By using silver paste as the adhesive, it is possible to connect the RF oscillator apparatus 10, the receiving mixer 18, and the amplifier 19 to the ground, respectively.

Thereafter, the wiring (e.g., the RF transmission line 8 and the DC bias terminals 9 and the like shown in FIG. 6) of the RF circuit substrate 23 constituting the module substrate, the electrode pads 2b of the MMIC chip 2 in the RF oscillator apparatus 10, the receiving mixer 18, and the amplifier 19 are, respectively, connected to one another by wire bonding the bonding wires 11 which are metal wires or the like (step S4).

Thereafter, the sealing of step S5 is carried out.

Here, the RF oscillator apparatus 10, the receiving mixer 18, and the amplifier 19 and the like which are loaded on the module substrate are sealed airtight by using the transceiving module upper cover 28.

Namely, the transceiver apparatus module base 27 and the transceiving module upper cover 28 are joined together by, for example, welding or the like, such that the interior of the transceiver apparatus is sealed airtightly.

In this way, such a transceiver apparatus can be assembled that the compact RF oscillator apparatus 10 whose frequency is set in advance and which is sub-modularized is built-in.

According to the manufacturing process of a transceiver apparatus which is the present first embodiment, the procedure thereof is one that the RF oscillator apparatus 10 whose frequency is set (adjusted) in advance and which is compactly sub-modularized is prepared and that the transceiver apparatus is assembled by building in the RF oscillator apparatus 10. Thus, it is easy to assemble the transceiver apparatus and it is possible to replace parts if there is something wrong with the parts during the assembly process.

Accordingly, improvements in both productivity and yield of the transceiver apparatus can be achieved.

Moreover, the present invention is a manufacturing process in which the RF oscillator apparatus 10 with frequency adjusted in advance as a sub-module is built into and sealed in a transceiver apparatus. Thus, the RF oscillator apparatus 10 which is a sub-module and having frequency adjusted is completely covered by the transceiving module upper cover 28 or the like, in order to be sealed airtightly. As a result, fluctuations in frequency can be prevented from occurring after the transceiver apparatus is completely assembled.

In this way, the reliability of the transceiver apparatus which is the present first embodiment can be improved relative to the frequency.

### (Second Embodiment)

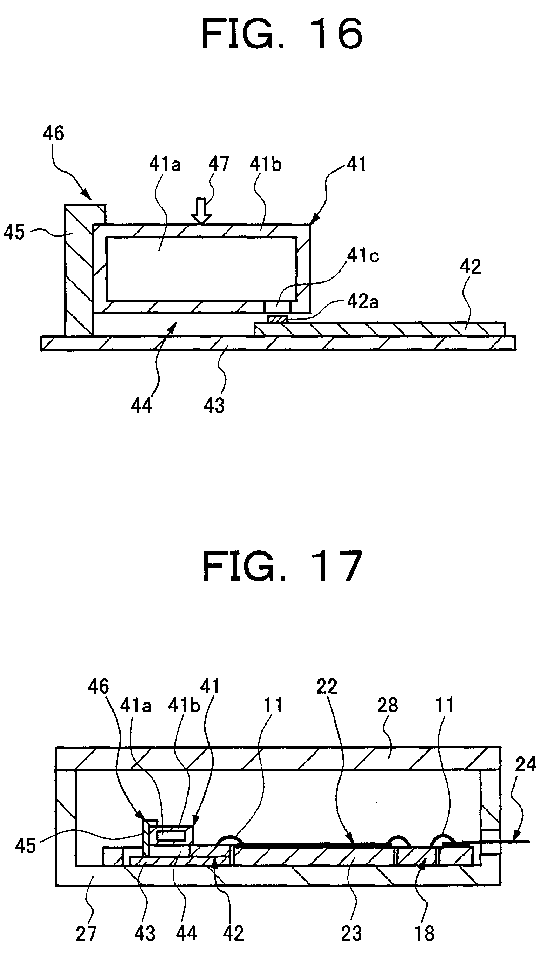

FIG. 16 is a sectional view showing an example of the structure of a RF oscillator apparatus using a cavity resonator which is a second embodiment of the present invention. FIG. 17 is a sectional view illustrating an example of a structure of a transceiver apparatus into which the RF oscillator apparatus shown in FIG. 16 is built.

The present second embodiment has such a structure that the dielectric resonator 1 described in the first embodiment is replaced by a cavity resonator 41 illustrated in FIG. 16.

Namely, the cavity resonator 41 is used as the resonator whose frequency is set in advance. By using the cavity resonator 41 whose frequency is set in advance, a RF oscillator apparatus 46 being compact and sub-modularized as shown in FIG. 16 is assembled. Further, the transceiver apparatus shown in FIG. 17 into which the RF oscillator apparatus 46 is built is assembled.

The RF oscillator apparatus 46 illustrated in FIG. 16 comprises the cavity resonator 41, a carrier (conductor plate) 43 supporting an MMIC chip 42 which is electromagnetically joined to the cavity resonator 41, and a dielectric supporter 45 which is a dielectric supporting member and which supports the cavity resonator 41. Therefore, the RF oscillator apparatus 46 is compact and sub-modularized such that the resonance frequency of the cavity resonator 41 can be set in advance.

The resonance frequency (oscillation frequency) of the cavity resonator 41 is adjusted by varying the volume of a cavity 41a enclosed by a conductive plate 41b. The cavity resonator 41 and an electromagnetic wave forming line 42a of the MMIC chip 42 are electromagnetically coupled via a window 41c which opens in the conductive plate 41b. Adjustment of the resonance frequency is carried out by deforming the conductive plate 41b in the direction of an arrow 47 shown in FIG. 16.

In this example, the cavity resonator 41 is supported by the dielectric supporter 45 so as to form an air gap 44 between the cavity resonator 41 and the carrier 43. In the case of utilizing the cavity resonator 41, because a cavity portion is already surrounded by a metal wall, it is particularly unnecessary to form the air gap 44 by using air. The air gap 44 may be a dielectric such as plastic or the like, or a metal plate made of copper, aluminum, or the like.

According to the RF oscillator apparatus 46 using the cavity resonator 41 of the present second embodiment, the second embodiment has no member corresponding to the conductive wall 4 provided in the RF oscillator apparatus 10 using the dielectric resonator 1 of the first embodiment. Thus, it is possible to make the RF oscillator apparatus 46 thin and compact.

The transceiver apparatus of the present second embodiment shown in FIG. 17 has the RF oscillation apparatus 46 in which the resonance frequency (oscillation frequency) of the cavity resonator 41 shown in FIG. 16 is set in advance, the receiving mixer 18 which is a receiving section being capable of receiving the RF signal generated from the RF oscillator apparatus, and the amplifier 19 (see FIG. 10) for amplifying the power. The difference between this transceiver apparatus and the transceiver apparatus of the first embodiment shown in FIG. 11 is that the RF oscillator apparatus 10 is replaced by the RF oscillator apparatus 46.

Accordingly, the other structures of the transceiver apparatus of the present second embodiment shown in FIG. 17 and the manufacturing process of the transceiver apparatus are the same as those of the transceiver apparatus of the first embodiment, and therefore, description overlapping with the first and second embodiments will be omitted.

According to both the RF oscillator apparatus 46 of the present second embodiment and the transceiver apparatus using the RF oscillator apparatus 46, since the cavity resonator 41 is used as the resonator, a member corresponding to the conductive wall 4 utilized in the RF oscillator apparatus 10 of the first embodiment is unnecessary. Accordingly, it is possible to form thinly the RF oscillator apparatus 46.

As a result, the second embodiment can make the transceiver apparatus thin and compact.

The other effects obtained by the RF oscillator apparatus 46 and the transceiver apparatus which is the present second embodiment are the same as those described in the first embodiment, and therefore, description about the effects overlapping with the first and second embodiments will be omitted.

As mentioned above, the present invention achieved by the present inventors is described concretely on the basis of the embodiments which is the present invention. However, the present invention is not to be limited to the above-described embodiments of the invention, and it goes without saying that various modifications can be achieved without departing from the scope and spirit of the present invention.

For example, in the above-described first embodiment, a case is described in which setting (adjusting) the oscillation frequency of the RF oscillator apparatus 10 is carried out by deforming the conductive wall 4 by using the implements 13 and 14 having the frequency adjusting screw 15 shown in FIG. 8. However, means other than the above-described method of using the implements may be used if the means for setting the oscillation frequency of the RF oscillator apparatus 10 (as well as the RF oscillator apparatus 46 of the second embodiment) is such a means as to be capable of deforming the conductive wall 4 which is disposed near the dielectric resonator 1.

Further, in the above-described first and second embodiments, cases are described in which silver paste is used as the adhesive when the RF oscillator apparatuses 10, 46, the receiving mixer 18, and the amplifier 19 are fixed to the module substrate, respectively. Instead of that, an adhesive other than silver paste may be used if the adhesive is conductive.

Moreover, the receiving mixer 18 and the amplifier 19 and the like of the transceiver apparatuses described in the first and second embodiments may be facedown connected by a flip chip technology using bumps of Au or the like at the microstrip line 22 on the RF circuit substrate (wiring substrate) 23.

In this case, since there is no need to provide the through holes 23a (see FIG. 10) for accommodating the receiving mixer 18, the amplifier 19 and the like at the wiring substrate 23, the module base 27 below the wiring substrate 23 may be connected to ground via through-hole wiring or multilayer wiring provided in the wiring substrate 23.

Effects obtained by typical embodiments of the invention disclosed in the present application will be briefly described hereinafter.
(1) By loading the dielectric resonator and the MMIC chip on the same conductor plate, a RF oscillator apparatus which is compactly sub-modularized and which has the oscillation frequency set in advance can be realized.
(2) Due to the above-mentioned (1), such a structure can be realized that a RF oscillator apparatus which is compactly sub-modularized and which has the oscillation frequency set in advance is built into a transceiver apparatus. Thus, the RF oscillator apparatus and the other RF circuits is easily connected to each other, and accordingly, it is possible to make the transceiver apparatus compact, and make the structure thereof simple.
(3) Due to the above-mentioned (2), a strong structure sufficient to be maintained with respect to mechanical vibrations can be realized. Fluctuations in the frequency of the RF oscillator apparatus can thereby be prevented. Accordingly, the performance of the transceiver apparatus can be improved, and the transceiver apparatus is effectively used as a vehicle-mounted transceiver apparatus.
(4) Due to the structure in which the compactly sub-modularized RF oscillator apparatus is built-in, it is easy to make, airtight, the entire transceiver apparatus including the MMIC chip, and a transceiver apparatus improving airtightness can be realized. As a result, the reliability of the transceiver apparatus can be improved.
(5) The method of adjusting the frequency in the present invention is difficult from a method of adjusting a screw which is mounted to a cap. Thus, the structure of the present invention can be simplified, and the number of parts can be reduced in comparison with the conventional screw-adjusting type structures. As a result, the costs of both the RF oscillator apparatus and the transceiver apparatus can be reduced.
(6) As the method of supporting the dielectric resonator at the conductor plate, the air gap is formed between the dielectric resonator and the conductor plate. In this way, a lowering of the Q of the dielectric resonator can be prevented, and it is possible to relax the need for positional accuracy of the dielectric resonator when the dielectric resonator is set.
(7) The manufacturing process for the transceiver apparatus is such an assembly process that the compactly sub-modularized RF oscillator apparatus is built-in. Therefore, it is possible to easily assemble the transceiver apparatus, and to replace parts if there is something wrong with the parts during the assembly. Accordingly, the present invention can improve the productivity and yield of the transceiver apparatus.
(8) The manufacturing process of the present invention is one that the RF oscillator apparatus, whose frequency is adjusted in advance, is built into and sealed in the transceiver apparatus as a sub-module. Therefore, the RF oscillator apparatus, whose frequency is adjusted can be completely covered, and fluctuations in frequency generated after completely assembling the transceiver apparatus can be prevented. In this way, the reliability of the transceiver apparatus can be improved relative to the frequency.

## Claims

1. A RF oscillator apparatus 10 comprising:
a conductor plate 3 supporting a dielectric resonator 1 and a microwave monolithic integrated circuit chip 2 which is electromagnetically coupled to the dielectric resonator; and
a conductive wall 4 which determines a resonance frequency of the dielectric resonator,
wherein the microwave monolithic integrated circuit chip 2 and the dielectric resonator 1 are provided on the same conductor plate.

2. A RF oscillator apparatus according to claim 1, wherein an air gap 5 is formed between the dielectric resonator 1 and the conductor plate 3.

3. A RF oscillator apparatus according to claim 1, wherein the dielectric resonator 1 is supported by a dielectric supporter 6 such that an air gap is formed between the dielectric resonator and the conductor plate.

4. A RF oscillator apparatus according to claim 3, wherein the dielectric supporter 6 has such a shape as to straddle both sides of the dielectric resonator 1, and is fixed on the conductor plate at the both sides of the dielectric resonator, and wherein the dielectric supporter 6 and a portion of an upper portion of the dielectric resonator 1 are jointed to each other.

5. A RF oscillator apparatus according to claim 1, wherein the conductive wall 4 covers an upper portion of the dielectric resonator.

6. A RF oscillator according to claim 1, 2, 3, 4 or 5,
wherein a chip capacitor 12 connected to the microwave monolithic integrated circuit chip is loaded on the conductor plate.

7. A transceiver apparatus comprising:
a RF oscillator apparatus 10 having a conductor plate 3 which supports a dielectric resonator 1, a microwave monolithic integrated circuit chip 2 which is electromagnetically coupled to the dielectric resonator, and a conductive wall 4 which determines a resonance frequency of the dielectric resonator;
a receiving section 18, 25 which makes a RF signal generated from the RF oscillator apparatus a local oscillation signal of a mixer; and
a transmitting section 17, 19 having an amplifier 19 for amplifying power.

8. A transceiver apparatus according to claim 7, wherein the RF oscillator apparatus 10 whose resonance frequency is set in advance is built into the transceiver apparatus.

9. A transceiver apparatus according to claim 7 or 8, wherein such a seal material 28 as to cover an upper portion of the conductive wall is provided.

10. A transceiver apparatus according to claim 7, 8 or 9, wherein the receiving section and the amplifier are constituted by microwave monolithic integrated circuit chips.

11. A transceiver apparatus comprising:
a RF oscillator apparatus 10 having a cavity resonator 1 and a conductor plate 3 which supports a microwave monolithic integrated circuit chip 2 electromagnetically coupled to the cavity resonator 1, a resonance frequency of the cavity resonator being set in advance;
a receiving section 18, 25 which makes a RF signal generated from the RF oscillator apparatus a local oscillation signal of a mixer 18; and
a transmitting section 17, 19 having an amplifier for amplifying power.

12. A manufacturing process of a transceiver apparatus, the process comprising the steps of:
preparing a RF oscillator apparatus whose resonance frequency is set in advance, a first semiconductor chip constituting a receiving section which makes a RF signal generated from the RF oscillator apparatus a local oscillation signal of a mixer, and a second semiconductor chip constituting a transmitting section having an amplifier for amplifying power;
fixing the RF oscillator apparatus and the first and second semiconductor chips to a module substrate by an adhesive;
connecting wires of the module substrate to the RF oscillator apparatus and the first and second semiconductor chips by wire bonding, respectively; and
airtightly sealing the RF oscillator apparatus and the first and second semiconductor chips loaded on the module substrate.

13. A manufacturing process of a transceiver apparatus according to claim 12, wherein the module substrate is used as a module substrate having a wiring substrate being connected by the wire bonding and a base substrate supporting the wiring substrate.

14. A manufacturing process of a transceiver apparatus according to claim 12 or 13, wherein the RF oscillator apparatus is used as a RF oscillator apparatus having a dielectric resonator, a conductor plate which supports a microwave monolithic integrated circuit chip electromagnetically coupled to the dielectric resonator, and a conductive wall which determines a resonance frequency of the dielectric resonator.

15. A manufacturing process of a transceiver apparatus according to claim 12, 13 or 14, wherein silver paste is used as the adhesive.
